# EUROPEAN PATENT APPLICATION

(11) **EP 4 716 419 A1**
(43) Date of publication of application: **25.03.2026**
(21) Application number: 23942997.0
(22) Date of filing: 30.06.2023
(51) Int. Cl.: H10F 39/12

(54) **IMAGE SENSOR, CAMERA MODULE, ELECTRONIC DEVICE, AND DISPLAY SYSTEM**

(71) Applicant: Huawei Technologies Co., Ltd., Shenzhen, Guangdong 518129 (CN)
(72) Inventor: ZHANG, Youming, Shenzhen, Guangdong 518129 (CN); LUO, Pengfei, Shenzhen, Guangdong 518129 (CN); LUO, Youquan, Shenzhen, Guangdong 518129 (CN); REN, Hui, Shenzhen, Guangdong 518129 (CN)
(74) Representative: Isarpatent
(86) International application number: PCT/CN2023/105084
(87) International publication number: WO 2025/000502

(57) **Abstract**

Embodiments of this application provide an image sensor, a camera module, an electronic device, and a display system. The image sensor includes a metasurface layer and an optical-to-electrical conversion layer that are disposed in a stacked manner. The optical-to-electrical conversion layer is configured to convert light transmitted through the metasurface layer into an electrical signal. The metasurface layer has a first micro-nano structure layer, the first micro-nano structure layer includes a plurality of microstructure arrays, each microstructure array includes a plurality of structure units arranged in an array, and structures of structure units of at least two microstructure arrays are different. The optical-to-electrical conversion layer has a plurality of photosensitive areas, and the plurality of photosensitive areas are in a one-to-one correspondence with a plurality of structure units at the metasurface layer. The image sensor, the camera module, the electronic device, and the display system provided in embodiments of this application can improve image quality.

## Description

### TECHNICAL FIELD

This application relates to the field of optical imaging technologies, and in particular, to an image sensor, a camera module, an electronic device, and a display system.

### BACKGROUND

An image sensor is a device that can convert an optical image into an electrical signal, and is widely used in electronic devices such as a mobile phone, a digital camera, a tablet computer, and a camera. For example, the image sensor is used in the digital camera. The digital camera projects an optical image onto the image sensor by using a lens assembly. The image sensor converts an optical signal of the image into an analog electrical signal and inputs the analog electrical signal into an electrical signal processor of the digital camera. The electrical signal processor converts the analog electrical signal into a digital signal, performs data processing on the digital signal, and outputs a photo. In a related technology, the image sensor obtains color information of an image by using a color filter, and the image sensor obtains light intensity information of the image by using an optical-to-electrical conversion element, and obtains a color image based on the light intensity information and the color information. However, an image obtained by an existing image sensor has a problem of low image quality. For example, the image has defects such as uneven luminance and uneven colors. Therefore, how to improve image quality of an image obtained by an image sensor becomes an urgent problem to be resolved.

### SUMMARY

Embodiments of this application provide an image sensor, a camera module, an electronic device, and a display system, to improve image quality.

A first aspect of this application provides an image sensor, including a metasurface layer and an optical-to-electrical conversion layer that are disposed in a stacked manner, where the optical-to-electrical conversion layer is configured to convert light transmitted through the metasurface layer into an electrical signal. The metasurface layer has a first micro-nano structure layer, the first micro-nano structure layer includes a plurality of microstructure arrays, each microstructure array includes a plurality of structure units arranged in an array, and structures of structure units of at least two microstructure arrays are different. The optical-to-electrical conversion layer has a plurality of photosensitive areas, and the plurality of photosensitive areas are in a one-to-one correspondence with a plurality of structure units at the metasurface layer.

The first micro-nano structure layer in the image sensor provided in this embodiment of this application includes a plurality of microstructure arrays, and structures of structure units of at least two microstructure arrays are different, so that the at least two microstructure arrays respond to incident light differently, that is, the structure units of the at least two microstructure arrays have different refractive indexes or transmittances for the incident light. Therefore, even if amounts of transmitted light are different, amounts of light received by photosensitive areas corresponding to structure units of different structures can be the same, that is, light intensity sensed by the photosensitive areas is the same. Therefore, structures of structure units in microstructure arrays at different positions are changed, so that light intensity sensed by corresponding photosensitive areas can be changed, light intensity of a corresponding part in an image meets a requirement, and light intensity of a part of or the whole image meets the requirement, thereby improving image quality. For example, light intensity of a local area or all areas of the image is controlled, so that light intensity of the entire image can be the same, thereby avoiding problems such as uneven luminance and/or uneven colors.

In addition, because the structures of the structure units of the at least two microstructure arrays are different, the metasurface layer has structure units of a plurality of structures, and the at least two microstructure arrays work at different angles. In this way, a working angle range of the metasurface layer may be increased, to improve image quality. For example, the working angle range of the metasurface layer is large, so that it can be ensured that both a luminance gain and a color gain at an edge of the image sensor are positive gains, thereby improving the image quality.

In a possible implementation, structures of structure units of any two microstructure arrays are different.

Structures of structure units of any two microstructure arrays in the image sensor provided in this embodiment of this application are different, so that structure units of different microstructure arrays respond to incident light differently, that is, the structure units of the different microstructure arrays have different refractive indexes or transmittances for the incident light. Therefore, even if amounts of light transmitted through the microstructure arrays are different, light received by photosensitive areas corresponding to the structure units of the microstructure arrays can be the same, and light intensity sensed by the photosensitive areas is the same. Therefore, when the structures of the structure units of the microstructure arrays are different, light intensity of areas of the image can be the same, thereby further improving the image quality. In addition, the light intensity sensed by the photosensitive areas is the same, and proportions of a plurality of colors meet a preset proportion, so that the problem of uneven colors does not occur in the image, thereby improving the image quality. In addition, because structures of structure units of different microstructure arrays are different, the microstructure arrays work at different angles. In this case, the working angle range of the metasurface layer can be increased, and it can be ensured that both the luminance gain and the color gain at the edge of the image sensor are positive gains, to improve the image quality.

In a possible implementation, center-to-center spacings of structure units of at least two microstructure arrays are different. In a direction perpendicular to a direction in which the metasurface layer and the optical-to-electrical conversion layer are stacked, the center-to-center spacing is a spacing between a center of the structure unit and a center of a corresponding photosensitive area.

Center-to-center spacings of structure units of at least two microstructure arrays of the image sensor provided in this embodiment of this application are different, so that structure units at different positions match chief ray angles corresponding to corresponding photosensitive areas, thereby better controlling light.

In a possible implementation, the plurality of microstructure arrays include a first microstructure array and a plurality of annular second microstructure arrays, and the plurality of second microstructure arrays sequentially surround the first microstructure array. In a radial direction of the second microstructure array and in a direction from the first microstructure array to the second microstructure array, center-to-center spacings of the structure units of the plurality of microstructure arrays gradually increase.

In the image sensor provided in this embodiment of this application, the plurality of second microstructure arrays sequentially surround the first microstructure array, and the center-to-center spacings of the structure units of the plurality of microstructure arrays gradually increase from inside to outside, so that distribution of the microstructure arrays is complementary to distribution of relative illuminance formed by shading, light intensity sensed by the photosensitive areas is the same, and the shading can be avoided in the image.

In a possible implementation, in a same microstructure array, center-to-center spacings of any two structure units are the same.

According to the image sensor provided in this embodiment of this application, center-to-center spacings of structure units in a same microstructure array are set to be the same, so that difficulty in manufacturing the metasurface layer can be reduced.

In a possible implementation, each structure unit includes a plurality of substructures, structures of at least two substructures in the plurality of substructures are different, and each substructure includes a plurality of columnar structures. Each photosensitive area includes a plurality of subareas, the plurality of subareas of each photosensitive area are in a one-to-one correspondence with a plurality of substructures of the corresponding structure unit, and each subarea corresponds to light in one color and is configured to convert the light in the corresponding color into an electrical signal.

The image sensor provided in this embodiment of this application refracts incident light by using the structure unit, so that light in different colors is refracted to corresponding subareas in the photosensitive areas, thereby implementing light splitting. In addition, each structure unit diffracts the incident light, so that the light in different colors can be transmitted to corresponding subareas in the corresponding photosensitive areas, thereby improving light utilization.

In a possible implementation, the image sensor further includes a color filter layer, the color filter layer is located between the metasurface layer and the optical-to-electrical conversion layer, the color filter layer includes a plurality of color filter units arranged in an array, and each color filter unit corresponds to one structure unit and one photosensitive area. Each color filter unit includes a plurality of color filter areas, each color filter area corresponds to one substructure and one subarea, and symmetry of each color filter area is the same as symmetry of the corresponding substructure.

According to the image sensor provided in this embodiment of this application, the color filter layer is disposed between the metasurface layer and the optical-to-electrical conversion layer, so that light transmitted to each subarea in a photosensitive area can be filtered, and light that is not in a corresponding color is filtered out, thereby avoiding interference to optical signal conversion of the optical-to-electrical conversion layer. In other words, a spectrum is further corrected, so that a color of light in each subarea is the same as a color corresponding to the subarea. In addition, the spectrum is further corrected by using the color filter layer, so that a requirement on a back-end image processing algorithm can be reduced. In addition, one structure unit corresponds to one color filter unit, to ensure that an arrangement period of structure units is consistent with an arrangement period of color filter units, and ensure that color control is periodic effect.

In addition, in the image sensor provided in this embodiment of this application, each color filter area corresponds to one substructure, and symmetry of the corresponding substructure is the same as that of the color filter area, so that each color filter area corrects a spectrum of light transmitted through the corresponding substructure, thereby ensuring that a color of light sensed by each subarea is the same as a color corresponding to the subarea.

In a possible implementation, an arrangement manner of the plurality of color filter areas of each color filter unit is any one of the following arrangement manners: red, green, green, and blue; red, yellow, yellow, and blue; red, green, blue, and white; red, yellow, blue, and white; and cyan, yellow, yellow, and magenta.

In a possible implementation, the image sensor further includes a second micro-nano structure layer, the second micro-nano structure layer is disposed between the metasurface layer and the optical-to-electrical conversion layer. The second micro-nano structure layer includes a plurality of micro-nano unit structures, and each micro-nano unit structure includes a plurality of micro-nano structures. Each micro-nano unit structure corresponds to one structure unit and one photosensitive area, and each micro-nano unit structure is configured to transmit light transmitted through the corresponding structure unit to the subareas of the corresponding photosensitive area.

According to the image sensor provided in this embodiment of this application, the second micro-nano structure layer is disposed between the metasurface layer and the optical-to-electrical conversion layer, so that light transmitted to each subarea in the photosensitive area can be filtered, and light that is not in a corresponding color is filtered out, thereby avoiding interference to optical signal conversion of the optical-to-electrical conversion layer. In other words, the spectrum is further corrected, so that the color of light in each subarea is the light in the color corresponding to the subarea. In addition, the spectrum is further corrected by using the second micro-nano structure layer, so that the requirement on the back-end image processing algorithm can be reduced.

In a possible implementation, each structure unit includes at least two types of media having different refractive indexes, and at least one type of medium in the at least two types of media having different refractive indexes is configured to form a columnar structure.

In the image sensor provided in this embodiment of this application, each structure unit includes at least two types of media having different refractive indexes, and at least one medium is configured to form a columnar structure, so that each structure unit has a plurality of spectral channels, and can diffract incident light to implement light splitting in a plurality of colors.

In a possible implementation, the metasurface layer further includes a substrate layer, and the substrate layer is located between the first micro-nano structure layer and the optical-to-electrical conversion layer and is connected to the first micro-nano structure layer.

In the image sensor provided in this embodiment of this application, the first micro-nano structure layer is connected to the substrate layer to form the metasurface layer, so that all microstructure arrays can be located on a same surface, thereby ensuring relative positions of the plurality of microstructure arrays, and manufacturing efficiency of the metasurface layer and assembly efficiency of the image sensor can be improved.

In a possible implementation, the substrate layer includes a planarization layer and a spacing layer that are disposed in a stacked manner, the spacing layer is located between the first micro-nano structure layer and the planarization layer, and the planarization layer is configured to connect to one of the color filter layer and the second micro-nano structure layer.

The substrate layer in the image sensor provided in this embodiment of this application includes the planarization layer and the spacing layer, and the spacing layer is located between the planarization layer and the first micro-nano structure layer, so that the plurality of microstructure arrays in the first micro-nano structure layer can be connected, the color filter layer or the second micro-nano structure layer can be planarized, and a surface of the substrate layer is flat.

In a possible implementation, the image sensor further includes an anti-reflection layer, and the anti-reflection layer covers a surface of the first micro-nano structure layer.

The anti-reflection layer in the image sensor provided in this embodiment of this application covers the surface of the first micro-nano structure layer, so that a transmittance of the incident light can be improved, and reflection of the incident light can be reduced, thereby improving light utilization.

A second aspect of this application provides a camera module, including a lens and the image sensor according to any one of the first aspect. A light exit side of the lens faces the metasurface layer of the image sensor.

A third aspect of this application provides an electronic device, including a processor and the camera module according to the second aspect. The processor is electrically connected to the image sensor of the camera module and is configured to process an electrical signal output by the image sensor.

A fourth aspect of this application provides a display system, including an image shooting device and a display device. The image shooting device includes the camera module according to the second aspect, and the display device is configured to display information collected by the image shooting device.

### BRIEF DESCRIPTION OF DRAWINGS

FIG. 1 is a diagram of a structure of an electronic device according to an embodiment of this application;
FIG. 2 is a diagram of a structure of a camera module according to an embodiment of this application;
FIG. 3 is a top view of a first micro-nano structure layer in FIG. 2;
FIG. 4 is a partial view of one microstructure array in FIG. 3;
FIG. 5 is a diagram of spacings between centers of structure units of different microstructure arrays in FIG. 3 and centers of corresponding photosensitive areas;
FIG. 6 is a diagram of an edge of a first microstructure array in FIG. 3;
FIG. 7 is a diagram of a center offset between a structure unit of a first microstructure array in FIG. 3 and a corresponding photosensitive area;
FIG. 8 is a diagram of a center offset between a structure unit of a second microstructure array in FIG. 3 and a corresponding photosensitive area;
FIG. 9 is a diagram of spacings between centers of structure units in a same microstructure array in FIG. 3 and centers of corresponding photosensitive areas;
FIG. 10A is a diagram of a structure in which a photosensitive area corresponds to a structure unit according to an embodiment of this application;
FIG. 10B is a diagram of a structure unit 13 in FIG. 3;
FIG. 11 is a diagram of a partial structure of a first type of color filter layer according to an embodiment of this application;
FIG. 12A is a diagram of a partial structure in FIG. 11 with a blue color filter area as a center;
FIG. 12B is a diagram of a partial structure in FIG. 4 with a third substructure as a center;
FIG. 12C is a diagram of a partial structure in FIG. 11 with a green color filter area as a center;
FIG. 12D is a diagram of a partial structure in FIG. 11 with a red color filter area as a center;
FIG. 13A is a diagram of a partial structure of a second type of color filter layer according to an embodiment of this application;
FIG. 13B is a diagram of a partial structure in FIG. 13A with a red color filter area as a center;
FIG. 13C is a diagram of a partial structure in FIG. 13A with a green color filter area as a center;
FIG. 13D is a diagram of a partial structure in FIG. 13A with a blue color filter area as a center;
FIG. 13E is a diagram of a partial structure in FIG. 13A with a white color filter area as a center;
FIG. 14 is a partial cross-sectional view of a first type of metasurface layer according to an embodiment of this application;
FIG. 15 is a partial cross-sectional view of a second type of metasurface layer according to an embodiment of this application;
FIG. 16 is a partial top view of a third type of metasurface layer according to an embodiment of this application;
FIG. 17 is a diagram of a structure of a first type of photosensitive area according to an embodiment of this application;
FIG. 18 is a diagram of a structure of a second type of photosensitive area according to an embodiment of this application;
FIG. 19 is a diagram of another type of first micro-nano structure layer different from that in FIG. 3 according to an embodiment of this application;
FIG. 20 is a diagram of a structure of a second type of image sensor different from an image sensor in FIG. 2 according to an embodiment of this application;
FIG. 21 is a diagram of a structure of a third type of image sensor different from an image sensor in FIG. 2 according to an embodiment of this application;
FIG. 22 is a diagram of a structure of a fourth type of image sensor different from an image sensor in FIG. 2 according to an embodiment of this application; and
FIG. 23 is a diagram of a structure of a fifth type of image sensor different from an image sensor in FIG. 2 according to an embodiment of this application.

Reference numerals:
100: image sensor;
10: metasurface layer;
   11: first micro-nano structure layer;
   12: microstructure array; 121: first microstructure array; 122: second microstructure array;
13: structure unit; 14: substructure; 14A: first substructure; 14B: second substructure; 14C: third substructure;
15: columnar structure;
16: substrate layer; 161: spacing layer; 162: planarization layer;
20: optical-to-electrical conversion layer; 21: photosensitive area; 22: subarea; 23: optical-to-electrical conversion element;
30: color filter layer; 31: color filter unit; 32: color filter area;
40: second micro-nano structure layer; 41: micro-nano unit structure; 42: micro-nano structure;
50: anti-reflection layer;
200: lens;
300: camera module;
400: processor; and
500: electronic device.

### DESCRIPTION OF EMBODIMENTS

For ease of understanding, the following explains related technical terms in embodiments of this application.

Shading, also known as vignetting, refers to a phenomenon in which luminance or color accuracy at an edge part of an image generated by a camera is different from that at a center of the image. The shading includes two types: luma shading and color shading.

Metamaterial (metamaterial): In a broad sense, the metamaterial refers to a complex of a unit structure that is designed manually and has a physical property that a conventional natural material does not have. The physical property of the metamaterial is mainly determined by a structure and arrangement of a unit structure of a subwavelength (far less than a wavelength).

Metasurface (metasurface): The metasurface is a two-dimensional form of the metamaterial, namely, a surface structure formed by a subwavelength micro unit structure.

Chief ray angle (chief ray angle, CRA): The chief ray angle is an included angle between a chief ray and an optical axis of a lens.

Chief ray of a lens: The chief ray of the lens refers to a ray that passes through a center of a stop, and a direction of the chief ray of the lens is in a one-to-one correspondence with a spatial position on an image plane.

Currently, a digital camera includes a lens assembly, an image sensor, and an electrical signal processor. The lens assembly projects an optical image onto the image sensor. The image sensor converts an optical signal of the image into an analog electrical signal and inputs the analog electrical signal to the electrical signal processor. The electrical signal processor converts the analog electrical signal into a digital signal, and outputs a photo after data processing. The image sensor obtains color information of the image by using a color filter array, obtains light intensity information of the image by using an optical-to-electrical conversion element array, and may obtain a color image with reference to the light intensity information and the color information.

However, due to an optical principle of the lens assembly, that is, a transmittance of light decreases with an increase of an incident angle, luminance at an edge of the image is inconsistent with luminance at a central area of the image, that is, a problem of uneven luminance occurs in the image, for example, luma shading. This reduces image quality. In other words, because a light concentration capability of a center of the lens assembly is far greater than that of an edge of the lens assembly, light intensity at a center of the image sensor is greater than that at a periphery, resulting in luma shading. In addition, due to mismatch between chief ray angles of the lens assembly and the image sensor, spectrums of light at different positions on the image plane are different, and proportions of red, green, and blue are also different, resulting in color shading. In addition, when actual proportions of light intensity at positions on a photosensitive surface of the image sensor deviate from a preset proportion, colors at positions of the image are also uneven. This reduces image quality. Therefore, how to improve image quality becomes an urgent problem to be resolved.

To resolve the luma shading, in a related technology, correction is mainly performed by using a back-end image signal processing (ISP) algorithm, that is, luminance distribution of an image received by an image sensor is determined through simulation or an experiment, and then luminance compensation is performed, to ensure that an image generated by the image sensor is evenly distributed in space. Although the problem of uniformity of luminance space on an image plane can be resolved, only amplification is performed on a signal, and a signal-to-noise ratio (signal noise ratio, SNR) difference caused by different light intensity cannot be resolved in this method. Therefore, although luminance of the image corrected by using the ISP algorithm seems to be uniform, a signal-to-noise ratio at a position at an edge of the image is still lower than that at a center of the image. In other words, the problem of luma shading cannot be resolved by using only the ISP algorithm.

To resolve the color shading, in a related technology, color correction of the ISP algorithm may be used to resolve the color shading. To be specific, color cast distribution of the image received by the image sensor is determined through simulation or an experiment, and a color correction matrix (color correction matrix, CCM) is adjusted in a spatial dimension to ensure spatial consistency of color response of the image generated by the image sensor. Although the spatial correction of the color correction matrix can be used resolve the problem of spatial uniformity or color cast of an image color to some extent, in an actual imaging process, a spectrum of a light source is very complex, and if only the color correction matrix is used for correction, serious color non-uniformity still occurs in some specific photographing scenarios. In other words, it is difficult to resolve the problem of color shading by using only the ISP algorithm. Therefore, how to improve image quality of an image obtained by an existing image sensor becomes an urgent problem to be resolved.

In view of this, embodiments of this application provide an image sensor 100, a camera module 300, an electronic device 500, and a display system. An amount of light received by at least some photosensitive areas 21 is controlled, so that light intensity sensed by the at least some photosensitive areas 21 meets a requirement, thereby improving image quality. For example, light intensity at each position of the image may be the same, to avoid defects such as uneven brightness and uneven colors of the image.

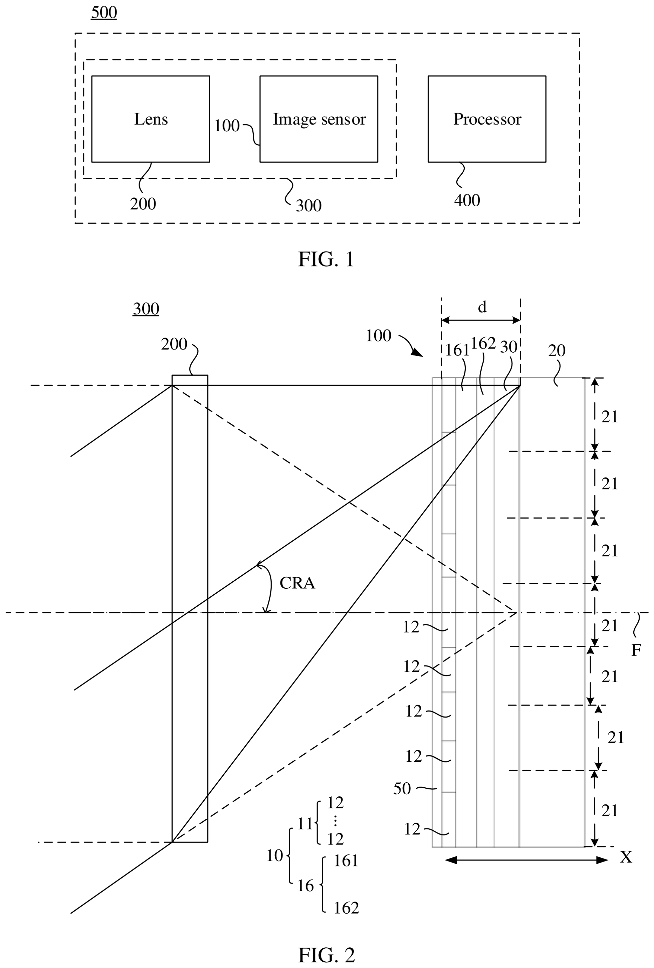

FIG. 1 is a diagram of a structure of an electronic device 500 according to an embodiment of this application. Refer to FIG. 1. An electronic device 500 provided in an embodiment of this application includes a camera module 300 and a processor 400. The camera module 300 includes a lens 200 and an image sensor 100. The image sensor 100 is electrically connected to the processor 400.

In an embodiment, the electronic device 500 includes a processor 400, a lens 200, and an image sensor 100. The image sensor 100 is electrically connected to the processor 400.

It should be understood that components included in the electronic device 500 provided in this embodiment of this application are not limited to the components in FIG. 1. For example, the electronic device 500 provided in this embodiment of this application may further include a battery, a flash, a button, a screen, and the like.

It should be understood that the lens 200 provided in this embodiment of this application may be a combination of a plurality of lenses. Certainly, the lens 200 may further include another element. For example, the lens 200 may further include a lens frame, and the lens frame is configured to carry the plurality of lenses.

The electronic device 500 provided in this embodiment of this application may include but is not limited to a handheld device, a wearable device (like a smartwatch), a computing device, a digital camera, a cellular phone (cellular phone), a smartphone (smart phone), a personal digital assistant (personal digital assistant, PDA) computer, a tablet computer, a laptop computer (laptop computer), a machine type communication (machine type communication, MTC) terminal, a point of sale (point of sales, POS), a vehicle-mounted device, a security protection device, a virtual reality (virtual reality, VR) device, and augmented reality device (augmented reality, AR), and another device with an imaging function.

An embodiment of this application further provides a display system. The display system includes an image shooting device and a display device. The image shooting device includes a camera module 300, the image shooting device is configured to collect information having an image and send the information to a display device, and the display device is configured to display the information collected by the image shooting device.

The image shooting device provided in this embodiment of this application may include but is not limited to a camera, a monitor, or the like.

The display device provided in this embodiment of this application may include but is not limited to a notebook computer, a display, a tablet computer, a mobile phone, or the like.

The following describes in detail the image sensor 100 and the camera module 300 provided in this embodiment of this application with reference to the accompanying drawings.

FIG. 2 is a diagram of a structure of the camera module 300 according to an embodiment of this application. As shown in FIG. 2, the camera module 300 provided in this embodiment of this application includes a lens 200 and an image sensor 100. The lens 200 is configured to image an optical image on the image sensor 100. The image sensor 100 includes an anti-reflection layer 50, a metasurface layer 10, a color filter layer 30, and an optical-to-electrical conversion layer 20 that are sequentially disposed in a stacked manner. The metasurface layer 10 includes a first micro-nano structure layer 11 and a substrate layer 16 that are disposed in a stacked manner. The substrate layer 16 includes a spacing layer 161 and a planarization layer 62. The first micro-nano structure layer 11 is located between the anti-reflection layer 50 and the spacing layer 161, and the planarization layer 62 is located between the color filter layer 30 and the spacing layer 161.

The substrate layer 16 of the image sensor 100 provided in this embodiment of this application includes the planarization layer 162 and the spacing layer 161, and the planarization layer 162 is located between the color filter layer 30 and the spacing layer 161, so that not only the first micro-nano structure layer 11 can be supported, but also a surface of the color filter layer 30 can be planarized.

In an embodiment, a material of the planarization layer 162 is an organic transparent material that can be spin-coated, and not only the surface of the color filter layer 30 can be planarized in a spin-coating manner, but also a high transmittance can be ensured.

In an embodiment, a material of the spacing layer 161 is an inorganic transparent material, for example, silicon dioxide. In this way, not only the planarization layer 162 and the first micro-nano structure layer 11 can be connected, but also a high transmittance can be ensured.

In this embodiment of this application, the anti-reflection layer 50 covers a surface of the first micro-nano structure layer 11, so that a transmittance of incident light can be improved, and reflection of the incident light can be reduced, thereby improving light utilization.

A material of the anti-reflection layer 50 is not specifically limited. For example, the material of the anti-reflection layer 50 may include but is not limited to magnesium fluoride, a fluorine-containing organic compound, silicon dioxide, a fluorine-containing polymer, and the like.

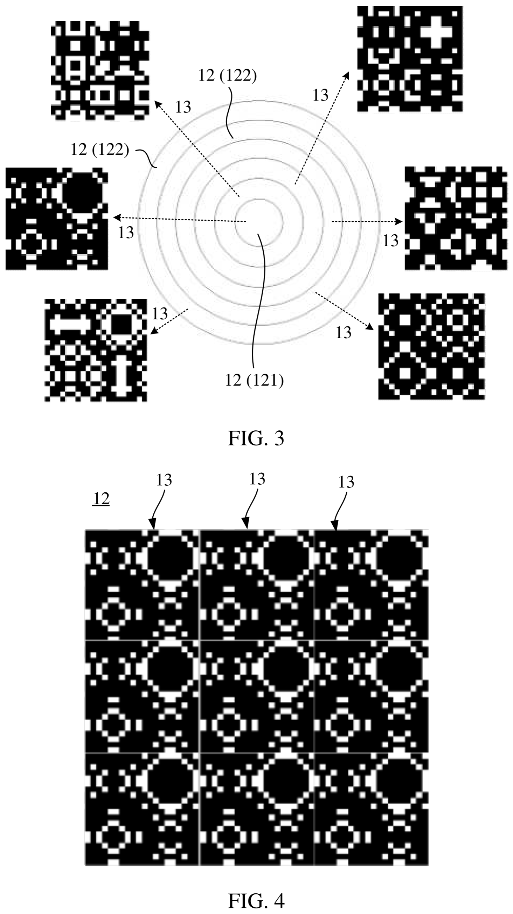

FIG. 3 is a top view of the first micro-nano structure layer 11 in FIG. 2, and FIG. 4 is a partial view of one microstructure array 12 in FIG. 3. With reference to FIG. 2, as shown in FIG. 3, and FIG. 4, the first micro-nano structure layer 11 includes a plurality of microstructure arrays 12, each microstructure array 12 includes a plurality of structure units 13 arranged in an array, and structures of structure units 13 of any two microstructure arrays 12 are different. The optical-to-electrical conversion layer 20 has a plurality of photosensitive areas 21, and the plurality of photosensitive areas 21 are in a one-to-one correspondence with a plurality of structure units 13 at the metasurface layer 10.

In this embodiment of this application, with reference to FIG. 2, the plurality of microstructure arrays 12 of the first micro-nano structure layer 11 are tiled on a same surface of the substrate layer 16. In other words, in a thickness direction of the image sensor 100 or a direction (for example, an X direction in FIG. 2) in which the metasurface layer 10 and the optical-to-electrical conversion layer 20 are stacked, projections of any two microstructure arrays 12 do not overlap, and a projection of each microstructure array 12 covers a part of a projection of the optical-to-electrical conversion layer 20.

In this embodiment of this application, structures of structure units 13 of any two microstructure arrays 12 are different. In other words, structures of two structure units 13 are different, and the two structure units 13 respectively belong to any two microstructure arrays 12 in the plurality of microstructure arrays 12. As shown in FIG. 3, in any two microstructure arrays 12, a structure of a structure unit 13 of one microstructure array 12 is different from a structure of a structure unit 13 of the other microstructure array 12.

In this embodiment of this application, a difference between structures of structure units 13 of any two microstructure arrays 12 may include but is not limited to a difference between shapes, sizes, and the like of the structure units 13.

Still refer to FIG. 3. Because structures of structure units 13 of any two microstructure arrays 12 are different, structure units 13 of different microstructure arrays 12 respond to incident light differently, that is, the structure units 13 of the different microstructure arrays 12 have different refractive indexes or transmittances for the incident light. Therefore, even if amounts of light transmitted through the structure units 13 of the different microstructure arrays 12 are different, amounts of light received by the photosensitive areas 21 can be the same or almost the same, and light intensity sensed by the photosensitive areas 21 is the same or almost the same. Therefore, on the premise that the light intensity sensed by the photosensitive areas 21 is the same, light intensity at positions of an image may be the same or almost the same, so that luminance at the positions of the image is consistent, and a problem of uneven luminance does not occur in the image. This improves image quality.

In addition, the light intensity sensed by the photosensitive areas 21 is the same, and an actual proportion of light intensity corresponding to each color is also consistent with a preset proportion, so that colors at the positions of the image are consistent, thereby avoiding a problem of uneven colors in the image and improving the image quality.

In addition, in comparison with a metasurface that is formed by arraying structure units 13 of a single structure in the conventional technology, which has a problem of a small working angle range, the metasurface layer 10 provided in this embodiment of this application has structure units 13 of a plurality of different structures, so that a working angle range of the metasurface layer 10 can be increased, to ensure that both a luminance gain and a color gain at an edge of the image sensor 100 are positive gains, and image quality can be improved.

In conclusion, the metasurface layer 10 of the image sensor 100 provided in this embodiment of this application includes a plurality of microstructure arrays 12, and structure units 13 of the microstructure arrays 12 correspondingly have different incident light, so that the metasurface layer 10 can control amounts of light received by the photosensitive areas 21 at the optical-to-electrical conversion layer 20, and light intensity sensed by the photosensitive areas 21 is the same, thereby improving image quality.

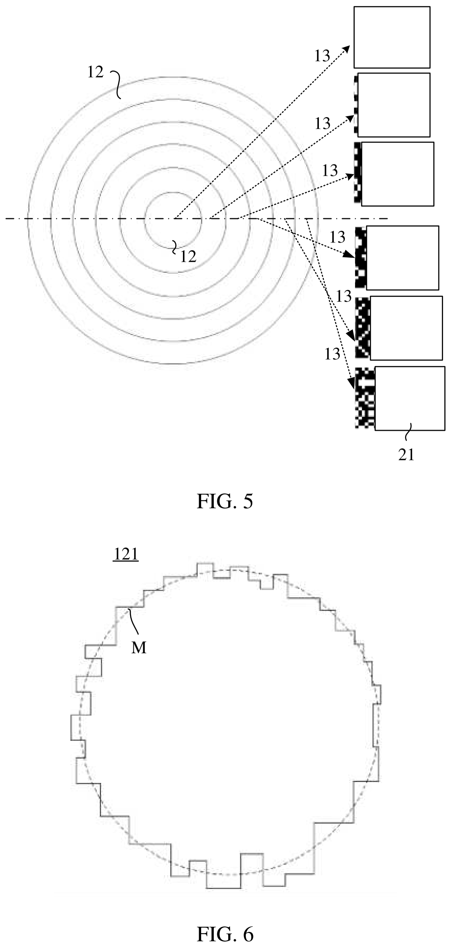

FIG. 5 is a diagram of spacings between centers of structure units 13 of different microstructure arrays 12 in FIG. 3 and centers of corresponding photosensitive areas 21. Refer to FIG. 5. In this embodiment of this application, the plurality of microstructure arrays 12 of the first micro-nano structure layer 11 include a first microstructure array 121 and a plurality of annular second microstructure arrays 122. The plurality of second microstructure arrays 122 sequentially surround the first microstructure array 121. In a radial direction of the second microstructure array 122 and in a direction from the first microstructure array 121 to the second microstructure array 122, center-to-center spacings of the structure units 13 of the plurality of microstructure arrays 12 gradually increase. In a direction perpendicular to the direction in which the metasurface layer 10 and the optical-to-electrical conversion layer 20 are stacked, the center-to-center spacing is a spacing between a center of the structure unit 13 and a center of a corresponding photosensitive area 21.

Correspondingly, in the image sensor 100 provided in this embodiment of this application, the plurality of second microstructure arrays 122 sequentially surround the first microstructure array 121, and the center-to-center spacings of the structure units 13 of the plurality of microstructure arrays 12 gradually increase, so that overall distribution of the plurality of microstructure arrays 12 is complementary to distribution of relative illuminance formed by shading. Therefore, under a condition that the structure units 13 of the microstructure arrays 12 respond to the incident light differently, light intensity sensed by the photosensitive areas 21 is the same, thereby avoiding a problem of shading in the image.

In this embodiment of this application, in the radial direction of the second microstructure array 122 and in the direction from the first microstructure array 121 to the second microstructure array 122, center-to-center spacings of the structure units 13 of the plurality of microstructure arrays 12 gradually increase. Refer to FIG. 5. In a radial direction of the first microstructure array 121 or the radial direction of the second microstructure array 122, the center-to-center spacings of the structure units 13 of the plurality of microstructure arrays 12 gradually increase from a center of the first microstructure array 121 outward. In other words, in the radial direction of the first microstructure array 121, a center-to-center spacing of any structure unit 13 of one microstructure array 12 in two adjacent microstructure arrays 12 is less than a center-to-center spacing of any structure unit 13 of the other microstructure array 12, and an outer diameter (or a diameter) of the microstructure array 12 is less than an outer diameter of the other microstructure array 12. It may be understood that, when the first microstructure array 121 is one of the microstructure arrays 12, one of the microstructure arrays 12 is circular, so that a diameter of the microstructure array 12 is less than an outer diameter of the other microstructure array 12.

Refer to FIG. 5. The first microstructure array 121 is circular, and the second microstructure array 122 is annular. Certainly, a shape of the first microstructure array 121 is not limited to a circle, and may be, for example, a rectangle. Similarly, it may be learned that a shape of the second microstructure array 122 is not limited to an annular ring. For example, the second microstructure array 12 may be of a rectangular ring structure.

Refer to FIG. 5. The first microstructure array 121 is circular. However, this does not mean that an edge of the first microstructure array 121 is circular shown in FIG. 5, but is quasi-circular shown in FIG. 6. A dashed line M in FIG. 6 is a boundary line of the first microstructure array 121 in FIG. 5. Similarly, when the second microstructure array 122 is annular, it does not mean that an inner edge and an outer edge of the second microstructure array 122 are circular shown in FIG. 5, which may alternatively be quasi-circular. Refer to the edge of the first microstructure array 121 in FIG. 6.

In this embodiment of this application, the center-to-center spacing of the structure unit 13 may be determined by using a relational expression shift=d*tan(CRA).

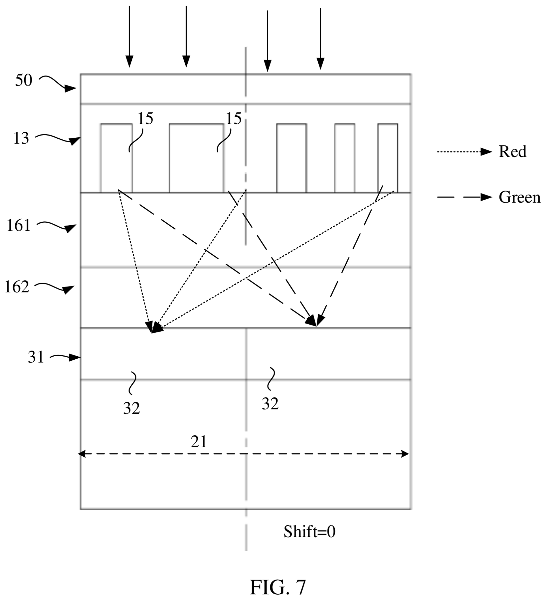

FIG. 7 is a diagram of a center offset between the structure unit 13 of the first microstructure array 121 in FIG. 3 and a corresponding photosensitive area 21. Refer to FIG. 3 and FIG. 7. It can be learned that a chief ray angle corresponding to the structure unit 13 of the first microstructure array 121 is 0°. Therefore, in a direction perpendicular to a direction in which the metasurface layer 10 and the optical-to-electrical conversion layer 20 are stacked, a spacing between a center of the structure unit 13 of the first microstructure array 121 and a center of the corresponding photosensitive area 21 is 0, that is, a center-to-center spacing of the structure unit 13 is 0.

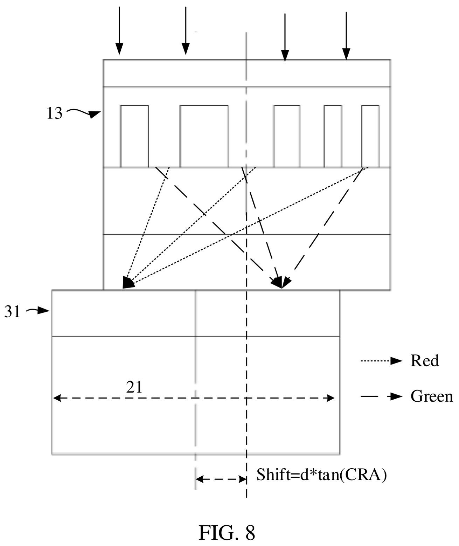

FIG. 8 is a diagram of a center offset between the structure unit 13 of the second microstructure array 122 in FIG. 3 and a corresponding photosensitive area 21. Refer to FIG. 3 and FIG. 8. It can be learned that a spacing between a center of each structure unit 13 of the second microstructure array 122 and a center of the corresponding photosensitive area 21 is obtained through calculation by using the foregoing relational expression: shift=d*tan(CRA).

Therefore, center-to-center spacings of the structure units 13 may be determined by using the relational expression shift=d*tan(CRA). Herein, shift is the center-to-center spacing of the structure unit 13, d is thickness of the metasurface layer 10 in a thickness direction of the image sensor 100, and CRA is a chief ray angle corresponding to each structure unit 13 (or a photosensitive area 2 corresponding to each structure unit 13).

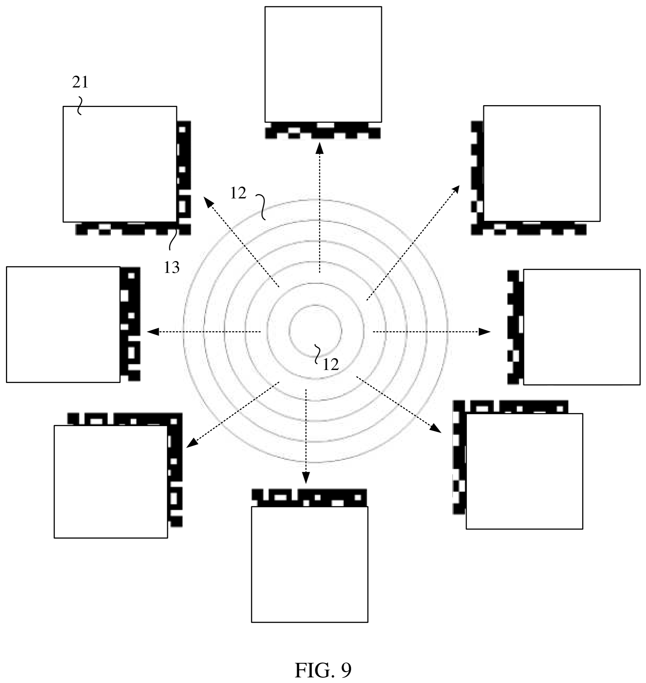

FIG. 9 is a diagram of spacings between centers of structure units 13 in a same microstructure array 12 in FIG. 3 and centers of corresponding photosensitive areas 21. Refer to FIG. 9. In this embodiment of this application, in the same microstructure array 12, center-to-center spacings of any two structure units 13 are the same.

However, in an embodiment, in the same microstructure array 12, in a radial direction of the microstructure array 12, center-to-center spacings of two adjacent structure units 13 are different (not shown in the figure).

Because an overall shape of the first micro-nano structure layer 11 is a circle, and with reference to the relational expression shift=d*tan(CRA) and FIG. 2, it can be learned that in a radial direction of the first micro-nano structure layer 11, each structure unit 13 corresponds to a different chief ray angle. Specifically, the chief ray angle gradually changes from a circle center from inside to outside in the radial direction of the first micro-nano structure layer 11. Therefore, in the same microstructure array 12, if center-to-center spacings of two adjacent structure units 13 are set to be different in the radial direction of the microstructure array 12, that is, center-to-center spacings of a plurality of structure units 13 gradually change in the radial direction of the first micro-nano structure layer 11, light can be better controlled. However, because a change amplitude of the chief ray angle is not large, a plurality of structure units 13 of different structures exist in the same microstructure array 12, which increases difficulty in manufacturing the metasurface layer 10. Therefore, in the same microstructure array 12, center-to-center spacings of all the structure units 13 are set to be the same, so that light can be better controlled, and the difficulty in manufacturing the metasurface layer 10 can be reduced.

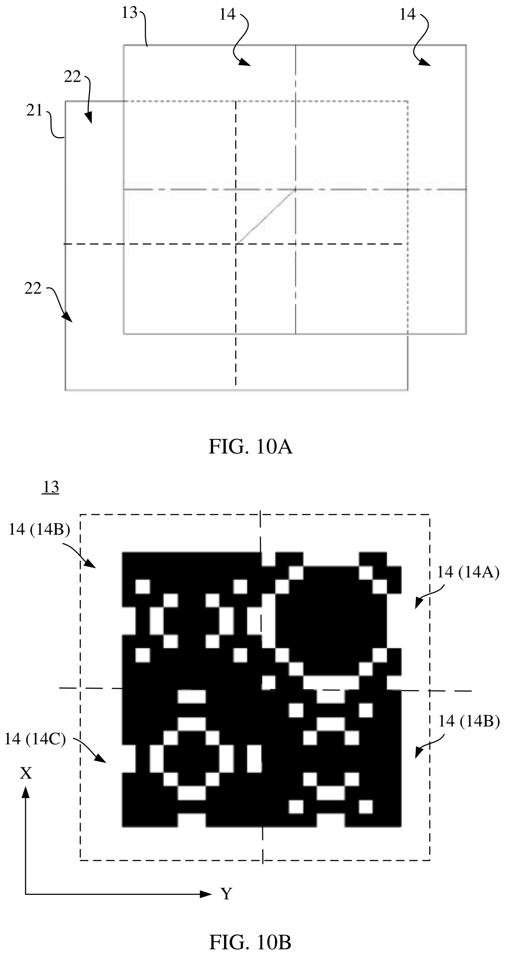

FIG. 10A is a diagram of a structure in which the photosensitive area 21 corresponds to the structure unit 13 according to an embodiment of this application. FIG. 10B is a diagram of the structure unit 13 in FIG. 3. Refer to FIG. 10A and FIG. 10B. In this embodiment of this application, each structure unit 13 includes a plurality of substructures 14, structures of at least two substructures 14 in the plurality of substructures 14 are different, and each substructure 14 includes a plurality of columnar structures 15. Each photosensitive area 21 includes a plurality of subareas 22, the plurality of subareas 22 of each photosensitive area 21 are in a one-to-one correspondence with a plurality of substructures 14 of the corresponding structure unit 13, and each subarea 22 corresponds to light in one color and is configured to convert the light in the corresponding color into an electrical signal.

Correspondingly, the image sensor 100 provided in this embodiment of this application refracts incident light by using the structure unit 13, so that light in different colors is refracted to corresponding subareas 22 in the photosensitive areas 21, thereby implementing light splitting. In addition, each structure unit 13 diffracts the incident light, so that light in different colors can be transmitted to corresponding subareas 22 in the corresponding photosensitive areas 21, thereby improving light utilization.

It should be understood that each subarea 22 corresponds to light in one color, which means that each subarea 22 is configured to receive light in one color and convert an optical signal of a corresponding color into an electrical signal.

It should be understood that colors of light corresponding to the plurality of subareas 22 of each photosensitive area 21 may include but are not limited to red, yellow, green, blue, white, and the like. In addition, the colors of the light corresponding to the plurality of subareas 22 of each photosensitive area 21 may be partially the same, that is, colors of light corresponding to a prat of subareas 22 in the plurality of subareas 22 of each photosensitive area 21 are the same, and colors of light corresponding to the other part of subareas 22 are different. Alternatively, colors of light corresponding to the plurality of subareas 22 of each photosensitive area 21 are different.

In this embodiment of this application, the plurality of subareas 22 of each photosensitive area 21 may be arranged in an arrangement manner such as RGGB (red, green, green, and blue), RYYB (red, yellow, yellow, and blue), or RGBW (red, green, blue, and white). For example, each photosensitive area 21 includes four subareas 22, two subareas 22 are used to receive green light, one of remaining two subareas 22 is used to receive red light, and the other is used to receive blue light. The four subareas 22 are arranged in a manner of red, green, green, and blue (RGGB).

In this embodiment of this application, a top view shape of each columnar structure 15 in each structure unit 13 may include but is not limited to a triangle, a quadrilateral, a hexagon, or the like. In addition, shapes of the columnar structures 15 in each structure unit 13 may be the same or different. In addition, the top view shape of each columnar structure 15 in each structure unit 13 is a shape on which seamless splicing can be performed. Because a plurality of columnar structures 15 in each structure unit 13 are similar, the plurality of columnar structures 15 are spliced into a large structure. For example, the columnar structure 15 may be a square structure, and a plurality of square structures may be spliced into a cuboid shape or another irregular shape due to the similarity.

Because each substructure 14 corresponds to one subarea 22, a quantity of types of substructures 14 of each structure unit 13 is the same as a quantity of colors corresponding to the subareas 22 of the corresponding photosensitive area 21. In addition, an arrangement manner of the plurality of substructures 14 of each structure unit 13 is the same as an arrangement manner of the plurality of subareas 22 of the corresponding photosensitive area 21, to ensure that the structure unit 13 transmits light in a corresponding color to a subarea 22 corresponding to the color in the photosensitive area 21.

In this embodiment of this application, structures of at least two substructures 14 in the plurality of substructures 14 of each structure unit 13 are different, and each substructure 14 corresponds to one subarea 22. For example, as shown in FIG. 10B, each structure unit 13 includes four substructures 14, structures of two substructures 14 (for example, 14B in FIG. 10B) in the four substructures 14 are the same, and the structures of the two substructures 14B and structures of two remaining substructures 14 (for example, 14A and 14C in FIG. 10B) are different. An arrangement manner of the four substructures 14 is the same as an arrangement manner of four corresponding subareas 22.

Because each structure unit 13 includes a plurality of substructures 14 of different structures, when light in different colors is refracted, refraction angles of the light in the different colors are changed, that is, propagation directions of the light in the different colors are controlled, so that the light in the different colors is transmitted to subareas 22 corresponding to the light in the different colors, to implement light splitting.

In this embodiment of this application, the color filter layer 30 includes a plurality of color filter units 31 arranged in an array, each color filter unit 31 corresponds to one structure unit 13 and one photosensitive area 21, and each color filter unit 31 includes a plurality of color filter areas 32. Each color filter area 32 corresponds to one substructure 14 and one subarea 22, and symmetry of each color filter area 32 is the same as symmetry of the corresponding substructure 14.

Correspondingly, the image sensor 100 provided in this embodiment of this application filters, by using the color filter layer 30, light transmitted to each subarea 22 in the photosensitive area 21, and filters out light that is not in a corresponding color, to avoid interference to optical signal conversion of the optical-to-electrical conversion layer 20. In other words, a spectrum is further corrected, so that a color of light in each subarea 22 is a color corresponding to the subarea 22. In addition, the spectrum is further corrected by using the color filter layer 30, so that a requirement on a back-end image processing algorithm can be reduced. In addition, one structure unit 13 corresponds to one color filter unit 31, to ensure that an arrangement period of structure units 13 is consistent with an arrangement period of color filter units 31, and ensure that color control is periodic effect.

In addition, the symmetry of each color filter area 32 is the same as the symmetry of the corresponding substructure 14, to ensure that light transmitted through each substructure 14 can be transmitted to the corresponding color filter area 32. For example, red light transmitted through the substructure 14 can be transmitted to a corresponding color filter area 32, so that a red subarea 22 can receive the red light.

In this embodiment of this application, in a thickness direction of the image sensor 100, each color filter area 32 covers a corresponding subarea 22, to ensure that light in one color is filtered and that the subarea 22 receives light in a corresponding color. For example, a color of light corresponding to the subarea 22 corresponding to the color filter area 32 is red. Correspondingly, the color filter area 32 can only transmit light in a filtered color, and filter out light in a color other than red.

In this embodiment of this application, each color filter area 32 includes one color filter, so that each color filter unit 31 includes a plurality of color filters arranged in an array, and the color filter layer 30 is formed by arranging the plurality of color filters in the array.

In this embodiment of this application, an arrangement manner of the plurality of color filter areas 32 of each color filter unit 31 may include but is not limited to red, green, green, and blue (RGGB), red, yellow, yellow, and blue (RYYB), red, green, blue, and white (RGBW), red, yellow, blue, and white (RYBW), and cyan, yellow, yellow, and magenta (CYYM).

In embodiments of this application, the arrangement manner of the plurality of color filter areas 32 of the color filter unit 31 is one of arrangement manners such as red, green, green, and blue (RGGB), red, yellow, yellow, and blue (RYYB), red, green, blue, and white (RGBW), red, yellow, blue, and white (RYBW), and cyan, yellow, yellow, and magenta (CYYM). However, in some embodiments, arrangement manners of the color filter areas 32 at the color filter layer 30 may include but are not limited to two or three types, for example, an arrangement manner corresponding to a part of color filter units 31 in the plurality of color filter units 31 is red, green, green, and blue, and an arrangement manner corresponding to another part of color filter units 31 is red, yellow, blue, and white.

In this embodiment of this application, after the arrangement manner of the plurality of color filter areas 32 of each color filter unit 31 is determined, symmetry of each color filter area 32 is also determined. In this case, symmetry of a substructure 14 corresponding to each color filter area 32 is also determined.

With reference to the accompanying drawings, the following describes, by using an example, how to determine the symmetry of the substructure 14 based on the arrangement manner of the plurality of color filter areas 32 of the color filter unit 31.

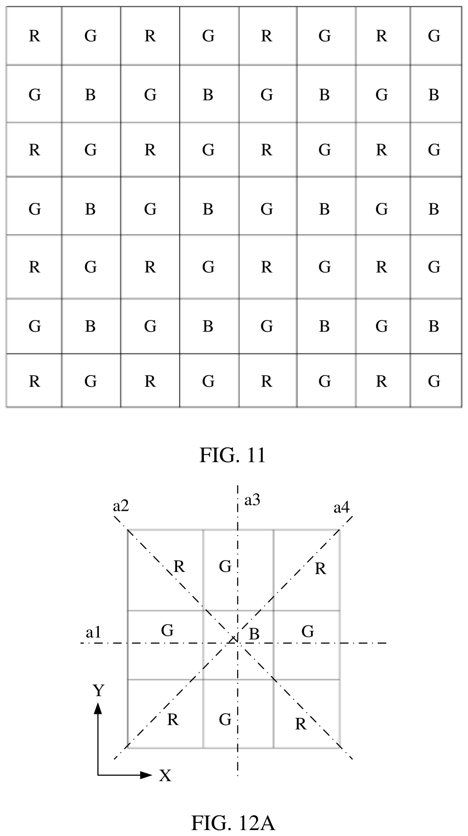

FIG. 11 is a diagram of a partial structure of a first type of color filter layer 30 according to an embodiment of this application. In an embodiment, it can be learned from FIG. 11 that, each color filter unit 31 includes four color filter areas 32, and an arrangement manner of the four color filter areas 32 is red, green, green, and blue (RGGB). Correspondingly, with reference to FIG. 10B, each structure unit 13 includes four substructures 14. The four substructures 14 include a first substructure 14A, a second substructure 14B, and a third substructure 14C. The first substructure 14A corresponds to a color filter area 32 that receives red, the second substructure 14B corresponds to a color filter area 32 that receives green, and the third substructure 14C corresponds to a color filter area 32 that receives blue.

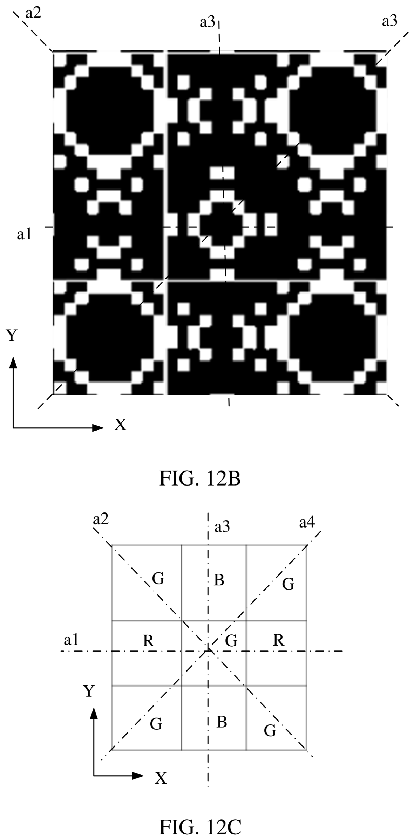

FIG. 12A is a diagram of a partial structure in FIG. 11 with a blue color filter area 32 as a center. Refer to FIG. 12A. Green color filter areas 32 are directly above, directly below, directly to the left, and directly to the right of a blue (B) area, and red color filter areas 32 are at four diagonal positions. A graph shown in FIG. 12A is separately folded along a symmetry axis a1, a symmetry axis a2, a symmetry axis a3, and a symmetry axis a4. It may be obtained that symmetry of the blue color filter area 32 is symmetric about four symmetry axes intersecting at one point, and an included angle between two adjacent symmetry axes in the four symmetry axes is 45°. Therefore, symmetry of a substructure 14 corresponding to the blue color filter area 32 in the structure unit 13 is determined. Refer to FIG. 12B. The third substructure 14C is symmetric about the symmetry axis a1, the symmetry axis a2, the symmetry axis a3, and the symmetry axis a4. FIG. 12B is a diagram of a partial structure in FIG. 4 with the third substructure 14C as a center.

FIG. 12C is a diagram of a partial structure in FIG. 11 with the green color filter area 32 as a center. Refer to FIG. 12C. Blue color filter areas 32 are directly above and directly below the blue (B) area, red color filter areas 32 are directly to the left and directly to the right, and green color filter areas 32 are at four diagonal positions. A graph shown in FIG. 12C is separately folded along the symmetry axis a1, the symmetry axis a2, the symmetry axis a3, and the symmetry axis a4. It may be obtained that symmetry of the green color filter areas 32 is symmetric about two symmetry axes intersecting at one point, and an included angle between the two symmetry axes is 90°. Therefore, symmetry of a substructure 14 corresponding to the green color filter area 32 in the structure unit 13 is also determined.

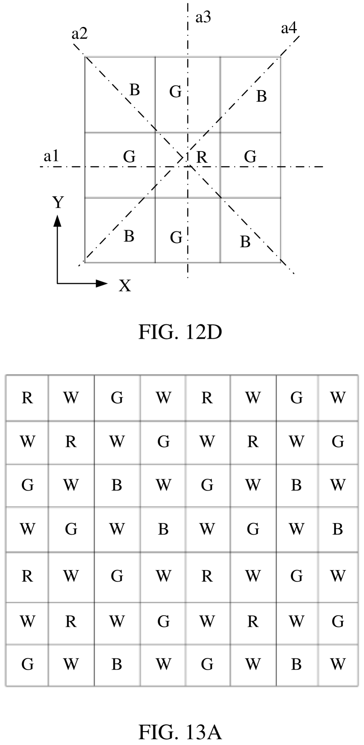

FIG. 12D is a diagram of a partial structure in FIG. 11 with the red color filter area 32 as a center. Refer to FIG. 12D. Green color filter areas 32 are directly above, directly below, directly to the left, and directly to the right of the blue (B) area, and blue color filter areas 32 are at four diagonal positions. A graph shown in FIG. 12D is separately folded along the symmetry axis a1, the symmetry axis a2, the symmetry axis a3, and the symmetry axis a4. It may be obtained that symmetry of the green color filter area 32 is symmetric about four symmetry axes intersecting at one point, and an included angle between two adjacent symmetry axes in the four symmetry axes is 45°. Therefore, symmetry of a substructure 14 corresponding to the red color filter area 32 in the structure unit 13 is also determined.

In conclusion, when the arrangement manner of the plurality of color filter areas 32 of the color filter unit 31 is RGGB, the red and blue color filter areas 32 are symmetric about the four symmetry axes, the included angle between two adjacent symmetry axes in the four symmetry axes is 45°, and the green color filter area 32 is symmetric about the two symmetry axes with the included angle of 90 degrees.

FIG. 13A is a diagram of a structure of a second type of color filter layer according to an embodiment of this application. In an embodiment, it can be learned from FIG. 13A that the color filter layer 30 includes a plurality of color filter groups, each color filter group includes four color filter units 31, an arrangement manner of the four color filter units 31 is red, green, blue, and white (RGBW), each color filter unit 31 includes four color filter areas 32, and an arrangement manner of the four color filter areas 32 is one of RWWR, GWWG, and BWWB. Correspondingly, each structure unit 13 includes four substructures 14, and each substructure 14 corresponds to a color filter area 32 of one color.

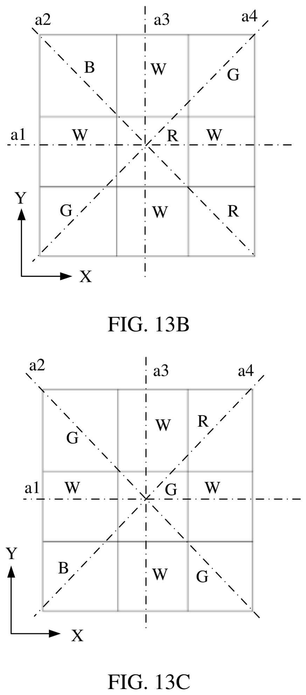

FIG. 13B is a diagram of a partial structure in FIG. 13A with a red color filter area 32 as a center. Refer to FIG. 13B. White color filter areas 32 are directly above, directly below, directly to the left, and directly to the right of a red (R) area, two green color filter areas 32 are at two diagonal positions, and blue and red color filter areas 32 are respectively at the other two diagonal positions. A graph shown in FIG. 13B is separately folded along a symmetry axis a1, a symmetry axis a2, a symmetry axis a3, and a symmetry axis a4. It may be obtained that symmetry of the red color filter area 32 is symmetric about a first diagonal (a2). Therefore, symmetry of a substructure 14 corresponding to the red color filter area 32 in the structure unit 13 is also determined.

FIG. 13C is a diagram of a partial structure in FIG. 13A with the green color filter area 32 as a center. Refer to FIG. 13C. White color filter areas 32 are directly above, directly below, directly to the left, and directly to the right of the red (R) area, two green color filter areas 32 are at two diagonal positions, and blue and red color filter areas 32 are respectively at the other two diagonal positions. A graph shown in FIG. 13C is separately folded along the symmetry axis a1, the symmetry axis a2, the symmetry axis a3, and the symmetry axis a4. It may be obtained that symmetry of the red color filter area 32 is symmetric about a second diagonal (a4). Therefore, symmetry of a substructure 14 corresponding to the green color filter area 32 in the structure unit 13 is also determined.

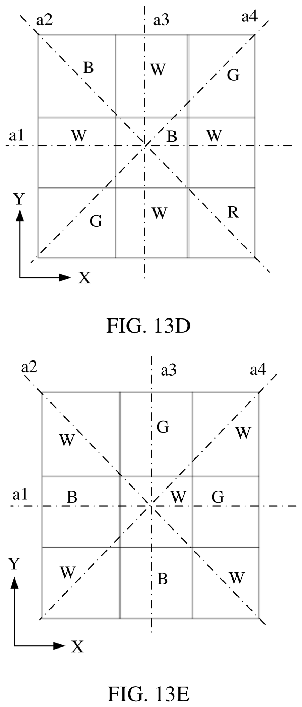

FIG. 13D is a diagram of a partial structure in FIG. 13A with the blue color filter area 32 as a center. Refer to FIG. 13D. White color filter areas 32 are directly above, directly below, directly to the left, and directly to the right of the red (R) area, two green color filter areas 32 are at two diagonal positions, and blue and red color filter areas 32 are respectively at the other two diagonal positions. A graph shown in FIG. 13D is separately folded along the symmetry axis a1, the symmetry axis a2, the symmetry axis a3, and the symmetry axis a4. It may be obtained that symmetry of the red color filter area 32 is symmetric about a first diagonal (a2). Therefore, symmetry of a substructure 14 corresponding to the blue color filter area 32 in the structure unit 13 is also determined.

FIG. 13E is a diagram of a partial structure in FIG. 13A with the white color filter area 32 as a center. Refer to FIG. 13E. Green color filter areas 32 are directly above and directly to the right of the red (R) area, and blue color filter areas 32 are directly below and directly to the left of the red (R) area. Four color filter areas 32 at four corners are all white color filter areas 32. A graph shown in FIG. 13E is separately folded along the symmetry axis a1, the symmetry axis a2, the symmetry axis a3, and the symmetry axis a4. It may be obtained that symmetry of the red color filter area 32 is symmetric about a second diagonal (a4). Therefore, symmetry of a substructure 14 corresponding to the white color filter area 32 in the structure unit 13 is also determined.

In conclusion, when the arrangement manner of the plurality of color filter areas 32 of the color filter unit 31 is RGBW, the red and blue color filter areas 32 are symmetric about the first diagonal, the white and green color filter areas 32 are symmetric about the second diagonal, and the first diagonal and the second diagonal are perpendicular and intersect at one point.

Therefore, after the arrangement manner of the color filter layer 30 is determined, the corresponding color filter area 32 and the color filter areas 32 surrounding the color filter area 32 are selected to determine symmetry of the color filter area 32.

In embodiments of this application, each structure unit 13 includes at least two types of media having different refractive indexes, and at least one type of medium in the at least two types of media having different refractive indexes is configured to form a columnar structure 15.

Correspondingly, in the image sensor 100 provided in this embodiment of this application, each structure unit 13 includes at least two types of media having different refractive indexes, and at least one medium is configured to form the columnar structure 15, so that each structure unit 13 has a plurality of spectral channels, and can diffract incident light to implement light splitting in a plurality of colors.

In embodiments of this application, a material of the medium may include but is not limited to titanium dioxide, gallium nitride, silicon nitride, air, vacuum, or the like.

In this embodiment of this application, each structure unit 13 has a same quantity of types of media, so that difficulty in manufacturing the metasurface layer 10 can be reduced. Certainly, in some embodiments, quantities of types of media included in the structure units 13 may alternatively be different.

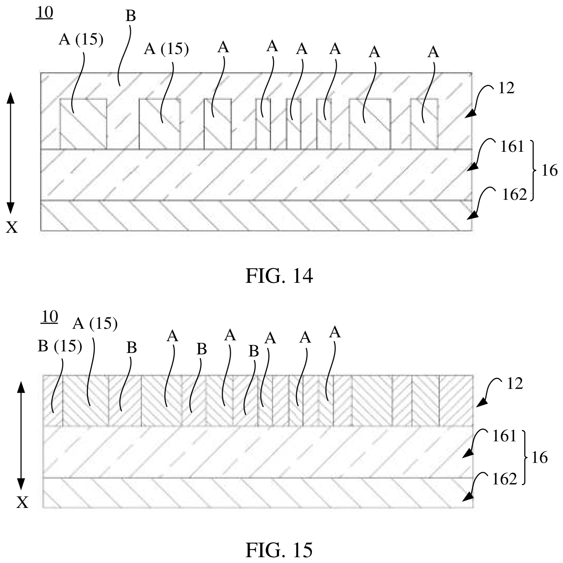

FIG. 14 is a partial cross-sectional view of a first type of metasurface layer 10 according to an embodiment of this application. Refer to FIG. 14. In an embodiment, each microstructure array 12 includes two types of media (as shown by A and B in FIG. 14) having different refractive indexes. One material in the two types of media forms the columnar structure 15 (as shown by A in FIG. 14), and an extension direction of the columnar structure 15 is parallel to the thickness direction of the image sensor 100. The other material in the two types of media is filled between adjacent columnar structures 15 and covers all columnar structures 15.

The materials of the two media are not specifically limited, for example, may be silicon nitride and silicon oxide, titanium dioxide and silicon dioxide, gallium nitride and silicon dioxide.

FIG. 15 is a partial cross-sectional view of a second type of metasurface layer 10 according to an embodiment of this application. Refer to FIG. 15. In an embodiment, each microstructure array 12 includes two types of media (as shown by A and B in FIG. 15) having different refractive indexes, and the two types of media each form a columnar structure 15. An extension direction of the columnar structure 15 is parallel to the thickness direction of the image sensor 100.

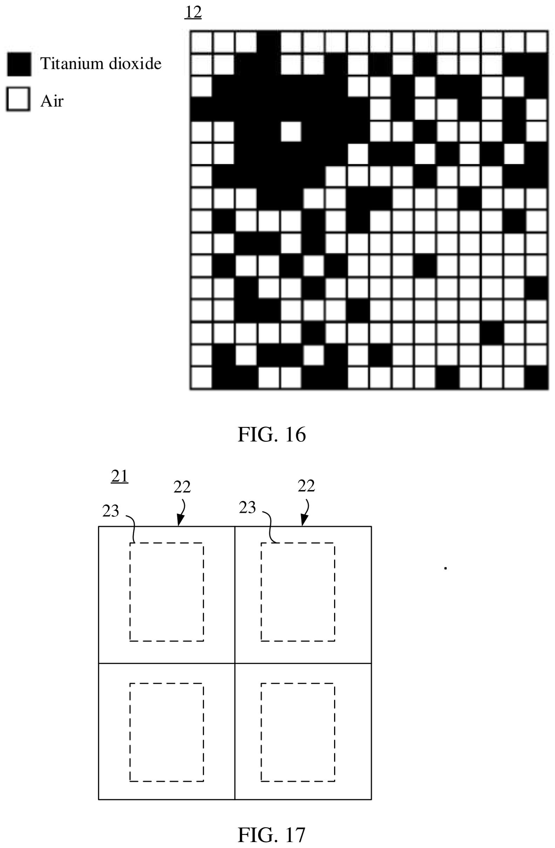

FIG. 16 is a partial top view of a third type of metasurface layer 10 according to an embodiment of this application. Refer to FIG. 16. Each microstructure array 12 includes two types of media having different refractive indexes. For example, the microstructure array 12 may be divided into a plurality of grids, each grid is filled with one medium, for example, titanium dioxide and air, and titanium dioxide forms a columnar structure 15.

Still refer to FIG. 16. Sizes of all the grids are the same. However, in an embodiment, sizes of all the grids may alternatively be different.

FIG. 17 is a diagram of a structure of a first type of photosensitive area 21 according to an embodiment of this application. Refer to FIG. 17. In this embodiment of this application, each photosensitive area 21 includes a plurality of subareas 22, each subarea 22 includes one optical-to-electrical conversion element 23, the plurality of optical-to-electrical conversion elements 23 are arranged in an array, and each optical-to-electrical conversion element 23 is configured to convert light in a corresponding color into an electrical signal.

The optical-to-electrical conversion element 23 may include but is not limited to a photodiode and a charge-coupled device (charge-coupled device, CCD) in a complementary metal-oxide-semiconductor (complementary metal oxide semiconductor, CMOS).

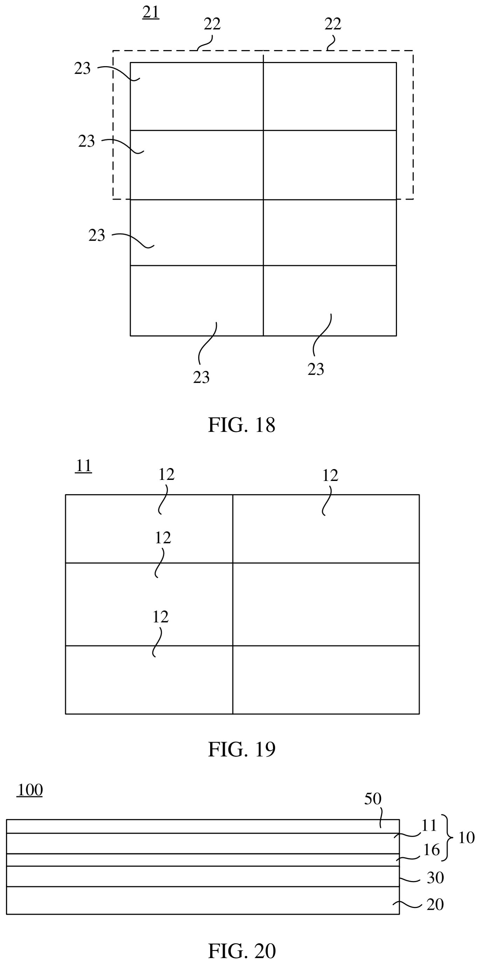

Certainly, each subarea 22 includes one optical-to-electrical conversion element 23, and may also include two or more optical-to-electrical conversion elements 23. FIG. 18 is a diagram of a structure of a second type of photosensitive area 21 according to an embodiment of this application. Refer to FIG. 18. In an embodiment, each subarea 22 includes two optical-to-electrical conversion elements, so that each color filter area 32 corresponds to two optical-to-electrical conversion elements 23.

In the foregoing content, the first micro-nano structure layer 11 includes the first microstructure array 121 and the second microstructure array 122. However, the first micro-nano structure layer 11 may alternatively include a microstructure array 12 of another shape. FIG. 19 is a diagram of another type of first micro-nano structure layer 11 different from that in FIG. 3 according to an embodiment of this application. In an embodiment, a difference between FIG. 19 and FIG. 3 lies in that the first micro-nano structure layer 11 is formed by arranging a plurality of rectangular microstructure arrays 12. The plurality of microstructure arrays 12 may be arranged in one dimension in a first direction, or the plurality of microstructure arrays 12 may be arranged in two dimensions in a first direction and a second direction, where the first direction is perpendicular to the second direction.

FIG. 20 is a diagram of a structure of a second type of image sensor 100 different from the image sensor 100 in FIG. 2 according to an embodiment of this application. Refer to FIG. 20. An image sensor 100 includes a metasurface layer 10 and an optical-to-electrical conversion layer 20 that are disposed in a stacked manner. The metasurface layer 10 includes a substrate layer 16 and a first micro-nano structure layer 11, and the substrate layer 16 is located between the first micro-nano structure layer 11 and the optical-to-electrical conversion layer 20. With reference to FIG. 2, it can be learned that a difference between FIG. 20 and FIG. 2 lies in that the substrate layer 16 has a different structure, and the substrate layer 16 is of a single-layer structure.

A material of the substrate layer 16 may include but is not limited to silicon dioxide, polymethyl methacrylate, or polycarbonate.

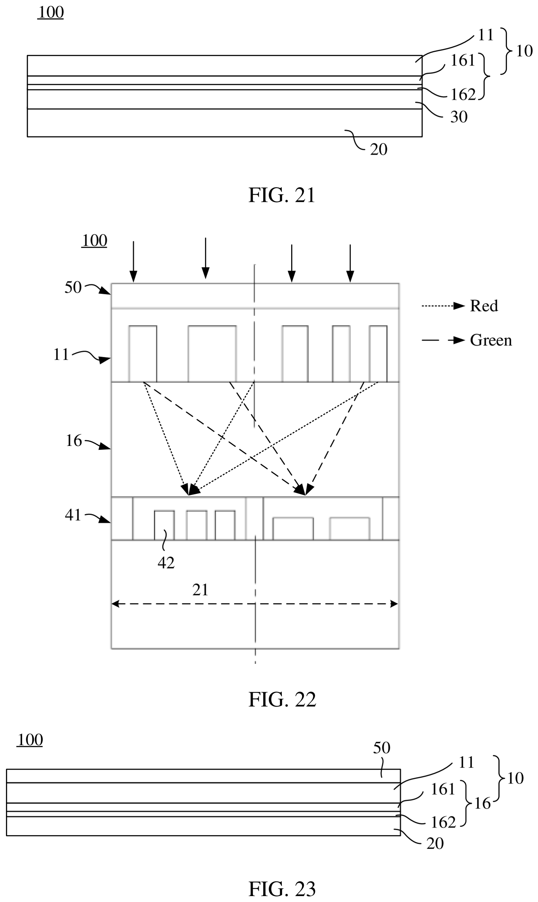

FIG. 21 is a diagram of a structure of a third type of image sensor 100 different from the image sensor 100 in FIG. 2 according to an embodiment of this application. A difference between FIG. 21 and FIG. 2 lies in that no anti-reflection layer 50 is disposed.

FIG. 22 is a diagram of a structure of a fourth type of image sensor 100 different from the image sensor 100 in FIG. 2 according to an embodiment of this application. A difference between FIG. 22 and FIG. 2 lies in that the color filter layer 30 is replaced with a second micro-nano structure layer 40, and a spectrum is further corrected by using the second micro-nano structure layer 40. Specifically, the second micro-nano structure layer 40 is disposed between a metasurface layer 10 and an optical-to-electrical conversion layer 20. The second micro-nano structure layer 40 includes a plurality of micro-nano unit structures 41, and each micro-nano unit structure 41 includes a plurality of micro-nano structures 42. Each micro-nano unit structure 41 corresponds to one structure unit 13 and one photosensitive area 21, and a center of each micro-nano unit structure 41 coincides with a center of the corresponding photosensitive area 21. Each micro-nano unit structure 41 is configured to transmit light transmitted through the corresponding structure unit 13 to a subarea 22 in the corresponding photosensitive area 21.

Correspondingly, according to the image sensor 100 provided in this embodiment of this application, the second micro-nano structure layer 40 is disposed between the metasurface layer 10 and the optical-to-electrical conversion layer 20, so that light transmitted to each subarea 22 in the photosensitive area 21 can be filtered, and light that is not in a corresponding color is filtered out, thereby avoiding interference to optical signal conversion of the optical-to-electrical conversion layer 20. In other words, a spectrum is further corrected, so that a color of light in each subarea 22 is light in a color corresponding to the subarea 22. In addition, the spectrum is further corrected by using the second micro-nano structure layer 40, so that a requirement on a back-end image processing algorithm can be reduced.

The micro-nano structure 42 may include but is not limited to a columnar structure 15, a hole structure, or the like.

A material of the micro-nano structure 42 may include but is not limited to a dielectric material, a metal material, or the like.

FIG. 23 is a diagram of a structure of a fifth type of image sensor 100 different from the image sensor 100 in FIG. 2 according to an embodiment of this application. A difference between FIG. 23 and FIG. 2 lies in that no color filter layer 30 is disposed.

In the foregoing content, center-to-center spacings of structure units 13 of any two microstructure arrays 12 are different. However, in some embodiments, center-to-center spacings of structure units 13 of any two microstructure arrays 12 may alternatively be the same.

Alternatively, in an embodiment, when there are at least three microstructure arrays 12, center-to-center spacings of structure units 13 of at least two microstructure arrays 12 in the at least three microstructure arrays 12 are the same, and center-to-center spacings of structure units 13 of a remaining microstructure array 12 are different from the center-to-center spacings of the structure units 13 of the at least two microstructure arrays 12. For example, there are four microstructure arrays 12, center-to-center spacings of structure units 13 of two microstructure arrays 12 are the same, and center-to-center spacings of structure units 13 of remaining two microstructure arrays 12 are different from the center-to-center spacings of the structure units 13 of the two microstructure arrays 12.

Correspondingly, center-to-center spacings of structure units 13 of a part of microstructure arrays 12 in the plurality of microstructure arrays 12 are controlled to be different, so that local light can be better controlled, to improve image quality.

That center-to-center spacings of structure units 13 of a plurality of microstructure arrays 12 in the plurality of microstructure arrays 12 are different may be determined based on whether chief ray angles corresponding to photosensitive areas 21 corresponding to the structure units 13 of the microstructure arrays 12 are different.

In the foregoing content, structures of structure units 13 of any two microstructure arrays 12 are different. However, in a possible implementation, when there are more than three microstructure arrays 12, structures of structure units 13 of one part of microstructure arrays 12 may be different, and structures of structure units 13 of the other part of microstructure arrays 12 may be the same. In other words, structures of structure units 13 of at least two microstructure arrays 12 are different.

It may be understood that the at least three microstructure arrays 12 are divided into two parts. Structures of structure units 13 of any two microstructure arrays 12 in one part are the same, structures of structure units 13 of any two microstructure arrays 12 in the other part are different, and there are at least two microstructure arrays 12 in the other part.

Structures of structure units 13 of a part of microstructure arrays 12 in the plurality of microstructure arrays 12 are different, so that light intensity sensed by a part of photosensitive areas 21 in the plurality of photosensitive areas 21 can be changed, to control light intensity of a part of areas in an image, thereby improving image quality.

It may be understood that when there are two microstructure arrays 12, structures of structure units 13 of the two microstructure arrays 12 are different.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. An image sensor, comprising a metasurface layer and an optical-to-electrical conversion layer that are disposed in a stacked manner, wherein the optical-to-electrical conversion layer is configured to convert light transmitted through the metasurface layer into an electrical signal, wherein
the metasurface layer has a first micro-nano structure layer, the first micro-nano structure layer comprises a plurality of microstructure arrays, each microstructure array comprises a plurality of structure units arranged in an array, and structures of structure units of at least two microstructure arrays are different; and
the optical-to-electrical conversion layer has a plurality of photosensitive areas, and the plurality of photosensitive areas are in a one-to-one correspondence with a plurality of structure units at the metasurface layer.

2. The image sensor according to claim 1, wherein structures of structure units of any two microstructure arrays are different.

3. The image sensor according to claim 1 or 2, wherein center-to-center spacings of structure units of at least two microstructure arrays are different; and
in a direction perpendicular to a direction in which the metasurface layer and the optical-to-electrical conversion layer are stacked, the center-to-center spacing is a spacing between a center of the structure unit and a center of a corresponding photosensitive area.

4. The image sensor according to claim 3, wherein the plurality of microstructure arrays comprise a first microstructure array and a plurality of annular second microstructure arrays, and the plurality of second microstructure arrays sequentially surround the first microstructure array; and
in a radial direction of the second microstructure array and in a direction from the first microstructure array to the second microstructure array, center-to-center spacings of the structure units of the plurality of microstructure arrays gradually increase.

5. The image sensor according to any one of claims 1 to 4, wherein in a same microstructure array, center-to-center spacings of any two structure units are the same.

6. The image sensor according to any one of claims 1 to 5, wherein each structure unit comprises a plurality of substructures, structures of at least two substructures in the plurality of substructures are different, and each substructure comprises a plurality of columnar structures; and
each photosensitive area comprises a plurality of subareas, the plurality of subareas of each photosensitive area are in a one-to-one correspondence with the plurality of substructures of the corresponding structure unit, and each subarea corresponds to light in one color and is configured to convert the light in the corresponding color into an electrical signal.

7. The image sensor according to claim 6, wherein the image sensor further comprises a color filter layer, the color filter layer is located between the metasurface layer and the optical-to-electrical conversion layer, the color filter layer comprises a plurality of color filter units arranged in an array, and each color filter unit corresponds to one structure unit and one photosensitive area; and
each color filter unit comprises a plurality of color filter areas, each color filter area corresponds to one substructure and one subarea, and symmetry of each color filter area is the same as symmetry of the corresponding substructure.

8. The image sensor according to claim 7, wherein an arrangement manner of the plurality of color filter areas of each color filter unit is any one of the following arrangement manners: red, green, green, and blue; red, yellow, yellow, and blue; red, green, blue, and white; red, yellow, blue, and white; and cyan, yellow, yellow, and magenta.

9. The image sensor according to claim 6, wherein the image sensor further comprises a second micro-nano structure layer, the second micro-nano structure layer is disposed between the metasurface layer and the optical-to-electrical conversion layer, the second micro-nano structure layer comprises a plurality of micro-nano unit structures, and each micro-nano unit structure comprises a plurality of micro-nano structures; and
each micro-nano unit structure corresponds to one structure unit and one photosensitive area, and each micro-nano unit structure is configured to transmit light transmitted through the corresponding structure unit to the corresponding photosensitive area.

10. The image sensor according to any one of claims 1 to 9, wherein each structure unit comprises at least two types of media having different refractive indexes, and at least one type of medium in the at least two types of media having different refractive indexes is configured to form a columnar structure.

11. The image sensor according to any one of claims 1 to 10, wherein the metasurface layer further comprises a substrate layer, and the substrate layer is located between the first micro-nano structure layer and the optical-to-electrical conversion layer and is connected to the first micro-nano structure layer.

12. The image sensor according to claim 11, wherein the substrate layer comprises a planarization layer and a spacing layer that are disposed in a stacked manner, the spacing layer is located between the first micro-nano structure layer and the planarization layer, and the planarization layer is configured to connect to one of the color filter layer and the second micro-nano structure layer.

13. The image sensor according to any one of claims 1 to 12, wherein the image sensor further comprises an anti-reflection layer, and the anti-reflection layer covers a surface of the first micro-nano structure layer.

14. A camera module, comprising a lens and the image sensor according to any one of claims 1 to 13, wherein a light exit side of the lens faces the metasurface layer of the image sensor.

15. An electronic device, comprising a processor and the camera module according to claim 14, wherein the processor is electrically connected to the image sensor of the camera module and is configured to process an electrical signal output by the image sensor.

16. A display system, comprising an image shooting device and a display device, wherein the image shooting device comprises the camera module according to claim 14, and the display device is configured to display information collected by the image shooting device.
